(19) Europäisches Patentamt
European Patent Office
Office européen des brevets

(11) **EP 3 579 002 B1**

(12) **EUROPÄISCHE PATENTSCHRIFT**

(45) Veröffentlichungstag und Bekanntmachung des Hinweises auf die Patenterteilung:
**01.03.2023   Patentblatt 2023/09**

(21) Anmeldenummer: **19176453.9**

(22) Anmeldetag: **24.05.2019**

(51) Internationale Patentklassifikation (IPC):
***G01R 27/18*** *(2006.01)*     *G01R 31/52* *(2020.01)*

(52) Gemeinsame Patentklassifikation (CPC):
**G01R 27/18;** G01R 31/52

(54) **EINRICHTUNG UND VERFAHREN ZUR MESSUNG VON ISOLATIONSWIDERSTAND UND ABLEITKAPAZITÄT BEI GESTÖRTEM MESSSIGNAL**

APPARATUS AND METHOD OF MEASURING INSULATING RESISTANCE AND DISCHARGE CAPACITY IN THE EVENT OF A DISRUPTED MEASUREMENT SIGNAL

DISPOSITIF ET PROCÉDÉ DE MESURE DE LA RÉSISTANCE À L'ISOLEMENT ET DE LA CAPACITÉ DE DÉRIVATION D'UN SIGNAL DE MESURE PERTURBÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.06.2018   DE 102018113426**

(43) Veröffentlichungstag der Anmeldung:
**11.12.2019   Patentblatt 2019/50**

(73) Patentinhaber: **ABB Schweiz AG**
**5400 Baden (CH)**

(72) Erfinder:
• **Zowislok, Florian**
**77960 Seelbach (DE)**
• **Witte, Franz-Otto**
**79331 Teningen (DE)**

(74) Vertreter: **Maiwald GmbH**
**Elisenhof**
**Elisenstraße 3**
**80335 München (DE)**

(56) Entgegenhaltungen:
**EP-A1- 2 256 506     EP-A1- 2 717 063**
**NL-A- 7 414 937**

• **MART MIN ET AL: "Binary signals in impedance spectroscopy", ENGINEERING IN MEDICINE AND BIOLOGY SOCIETY (EMBC), 2013 35TH ANNUAL INTERNATIONAL CONFERENCE OF THE IEEE, IEEE, 28. August 2012 (2012-08-28), Seiten 134-137, XP032462878, ISSN: 1557-170X, DOI: 10.1109/EMBC.2012.6345889**
• **SCHROEDER M R: "Integrated-impulsem ethod measuring sound decay without using impulses", THE JOURNAL OF THE ACOUSTICAL SOCIETY OF AMERICA, AMERICAN INSTITUTE OF PHYSICS FOR THE ACOUSTICAL SOCIETY OF AMERICA, NEW YORK, NY, US, Bd. 66, Nr. 2, 1. Januar 1979 (1979-01-01) , Seiten 497-500, XP007901309, ISSN: 0001-4966, DOI: 10.1121/1.383103**

EP 3 579 002 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung geht aus von einem Verfahren zur Bestimmung des Isolationswiderstandes in einem ungeerdeten elektrischen Gleich-oder Wechselstromnetz, wobei das Gleich- oder Wechselstromnetz einen ohmschen ($R_f$) sowie kapazitiven ($C_f$) Isolationswiderstand zwischen Netz und Erde aufweist, wobei eine periodisch sich wiederholende Folge von Spannungsimpulsen über eine ohmsche Netzankopplung ($R_i$) zwischen Netz und Erde an das zu überwachende Gleich-oder Wechselstromnetz angelegt wird.

Die Erfindung betrifft damit ein Verfahren zur Bestimmung des Isolationswiderstandes und der Ableitkapazität eines potentialfreien spannungsbehafteten IT-Netzes bei gestörtem Messsignal. Das IT-Netz ist durch Ableitwiderstände und -Kapazitäten mit dem Erdpotential verbunden. In einem vereinfachten Modell wird die Parallelschaltung aller Ableitwiderstände als "$R_f$" und die Parallelschaltung aller Ableitkapazitäten "$C_f$" betrachtet. Um deren Wert zu bestimmen, wird ein Messsignal "$U_g$" angelegt, das über eine Messimpedanz "$R_m$" einen Stromfluss durch $R_f$ und $C_f$ erzeugt. Aus bekanntem Messsignal, Messimpedanz und gemessenem Stromfluss lassen sich $R_f$ und $C_f$ bestimmen. Eine Störspannung, die sich zum Messsignal addiert, führt jedoch unweigerlich zu Fehlmessungen. In praktischen Anwendungsfällen, wie Solaranlagen mit Wechselrichtern, gibt es Konfigurationen, in denen eine messtechnische Erfassung der Störgröße nicht möglich oder nicht praktikabel ist. Es können jedoch gewisse, praxisnahe Annahmen über das Störsignal getroffen werden, wie die Annahme, dass das Störsignal eine gewisse Regelmäßigkeit aufweist und im Spektrum der Störungen nur wenige Störfrequenzen relevant sind. Eine Messung mit einem sinusförmigen ungestörten Messsignal liefert allerdings nur dann exakte Ergebnisse, wenn das Störspektrum bei der Frequenz des Messsignals keine Energieanteile besitzt. Da das Störsignal und damit auch dessen Spektrum nicht bekannt ist, gibt es einen Bedarf für ein verbessertes Verfahren zur Bestimmung des Isolationswiderstandes und der Ableitkapazität eines potentialfreien spannungsbehafteten IT-Netzes bei gestörtem Messsignal,

In der EP 2717 063 A1 wird ein Verfahren zur Überwachung und Messung eines Isolationswiderstandes in ungeerdeten und geerdeten Stromversorgungssystemen offenbart, umfassend die Verfahrensschritte:

- Erzeugung eines periodischen Messsignals,
- Einkopplung des Messsignals zwischen aktiven Leitern des zu überwachenden Stromversorgungssystems und Erde,
- Erfassung und Auswertung von Messsignal-Messwerten ,

wobei das erzeugte Messsignal als Multifrequenz-Signal durch eine Rechteckimpuls-Folge konstruiert wird, wobei ein die Folge bildender Rechteckimpuls in m gleichlange Teilabschnitte unterteilt wird, die m Teilabschnitte in geordneter Vorgehensweise jeweils binärwertig entweder unipolar auf 0/1 oder bipolar auf -1/+1 gesetzt werden, für jede der $2^m$ möglichen Rechteckimpuls-Folgen Fourier-Koeffizienten für ausgewählte Harmonische berechnet werden, und eine Auswahl derjenigen Rechteckimpuls-Folge getroffen wird, die vorgegebene Anforderungen an ihre spektrale Zusammensetzung erfüllt.

Die EP 2 256 506 A1 offenbart ein Verfahren und eine Vorrichtung zur Isolationsüberwachung eines ungeerdeten Gleich- und/oder Wechselspannungsnetzes. Dabei umfasst das Verfahren das Anlegen einer Messspannung welche aus einer periodischen Impulsfolge mit drei vordefinierten Impulsspannungswerten gebildet ist. Abschließend wird ein Isolationswiderstand und eine Isolationsimpedanz auf Basis der Messspannung bestimmt.

Der vorliegenden Erfindung liegt im Lichte des Standes der Technik die Aufgabe zugrunde, ein gattungsgemäßes Verfahren so weiterzuentwickeln, dass es auf vereinfachte und verbesserte Art und Weise auch unter dem Einfluss von Störungen auswertbare Ergebnisse nebst eines Bewertungskriteriums für die Zuverlässigkeit der Messung liefert.

Die Aufgabe wird erfindungsgemäß durch ein Verfahren gemäß Anspruch 1 gelöst.

Erfindungsgemäß wird also ein neuartiges Messsignal verwendet, das den für die Messung relevanten Frequenzbereich durch äquidistante gleichstarke Spektralkomponenten abdeckt, und das im Zeitbereich durch ein abgetastetes 3-wertiges periodisches Zeitsignal repräsentiert wird, dessen Periodenlänge einer Primzahl P entspricht. Die Abtastwerte sind als sogenannte "Legendrefolge" ausgebildet.

Eine Legendre-Folge ist eine ternäre Folge mit Elementen {0, 1, -1}. Ihr Bildungsgesetz lautet:

$$S(n) = n^{(p-1)/2} \bmod p, \text{ mit } p = \text{Primzahl} > 2.$$

Legendre-Folgen existieren für alle primzahligen Längen N = p. Für N = p = 7 erhält man beispielsweise (mit 6 = -1 mod 7) die Folge

$$S(n) = 0, 1, 1, -1, 1, -1, -1.$$

Die Legendrefolge hat die Eigenschaft, dass deren Spektralzerlegung P-1 Spektralkomponenten mit der gleichen Signalenergie aufweisen und der Gleichanteil die Spektralenergie 0 aufweist.

Für jede der P-1 Spektralkomponenten wird der Ableitwiderstand bestimmt. Unter der obigen Voraussetzung, dass nur wenige Spektralkomponenten gestört sind, wird die Mehrzahl der bestimmten Ableitimpedanzen ähnliche Ergebnisse aufweisen. Durch Aussortieren der stark abweichenden Impedanzwerte und einer Mittelung der verbleibenden Ergebnisse, wird der Einfluss der Störgröße eliminiert oder reduziert.

Die Erfindung beschreibt also ein verbessertes Verfahren zur Überwachung und Messung eines Isolationswiderstandes in ungeerdeten elektrischen Gleichstrom- und Wechselstromnetzen, die einen unvermeidbaren ohmschen, sowie kapazitiven Isolationswiderstand zwischen Netz und Erde aufweisen, in dem drei verschiedene nach einem bestimmten Muster vordefinierte periodische Impulsspannungswerte über eine ohmsche Netzankopplung zwischen Netz und Erde an das zu überwachende Netz angelegt wird. Die Zahl der in einer Periode angelegten Impulsspannungswerte entspricht einer Primzahl P und die Amplitude der Impulsspannungswerte wird durch Legendre-Folgen definiert. Die durch die angelegte Impulsspannungsfolge hervorgerufene Spannungsänderung des Netzes wird spektral zerlegt und jede Spektralkomponente zur entsprechenden Spektralkomponente der eingangsseitigen Impulsfolge in Beziehung gesetzt. Jede dieser Relationen ermöglicht die rechentechnische Ermittlung des ohmschen und kapazitiven Isolationswiderstand, wobei die Rechenergebnisse frequenzunabhängig bei einem ungestörten System gleiche Werte liefern. In einem System, in dem einzelne Frequenzen gestört sind, werden die ermittelten Werte bei den gestörten Frequenzen stark abweichen. Durch Identifikation der von der Majorität abweichenden Messergebnisse können diese von einem anschließenden Mittelungsschritt eliminiert werden, wodurch der Einfluss von schmalbandigen Störern unbekannter Frequenz reduziert wird.

In dem erfindungsgemäßen Verfahren sind beim Messsignal 3 Signalzustände zulässig, nämlich 0,-1 und +1, wobei der Wert 0 nur einmal in der Periode auftaucht. Weiterhin ist die Signalfolge, im Gegensatz zu der im Stand der Technik bekannten Lösung, nicht aufgrund eines Optimierungsverfahrens, sondern durch eine einfache mathematische Vorschrift ermittelt worden.

Gemäß einer vorteilhaften Ausführungsform des erfindungsgemäßen Verfahrens erzeugt ein Messsignalgenerator aus einer geschalteten Gleichspannungsquelle ein Messsignal, das als eine sich wiederholende Folge von Spannungsimpulsen mit drei verschiedenen, vordefinierten Impulsspannungswerten gebildet ist, wobei die Anzahl der in einer Periode angelegten Spannungsimpulse einer Primzahl entspricht, wobei die Amplitude der Impulsspannungswerte durch eine Legendre-Folge definiert ist.

Gemäß einer vorteilhaften Ausführungsform des erfindungsgemäßen Verfahrens wird die Berechnung der Werte der Legendre-Folge im Vorfeld der Messung durchgeführt, so dass der Messsignalgenerator seine Ausgabewerte einer vorab berechneten Wertetabelle entnehmen kann.

Gemäß einer vorteilhaften Ausführungsform des erfindungsgemäßen Verfahrens tasten ein erster Abtaster das von dem Messsignalgenerator erzeugte Messsignal und ein zweiter Abtaster das Signal der Systemantwort des Gleich-oder Wechselstromnetzes mit einer festen Frequenz ab, wodurch abgetastete Spektren UG(k) und UL(k) entstehen, wobei die Abtastfrequenz so bemessen ist, dass sie einem ganzzahligen Teiler der Impulsdauer der durch den Messsignalgenerator erzeugten Spannungsimpulse entspricht.

Gemäß einer vorteilhaften Ausführungsform des erfindungsgemäßen Verfahrens werden die abgetasteten Spektren UG(k) und UL(k) einem Berechnungsblock zugeführt werden, in dem pro Spektrallinie ein Wert für den ohmschen Widerstand Rf ermittelt wird.

Gemäß einer vorteilhaften Ausführungsform des erfindungsgemäßen Verfahrens werden die Werte der pro Spektrallinie ermittelten Werte für den ohmschen Widerstand Rf miteinander verglichen und Ausreißer aufgrund vorgebbarer Kriterien ermittelt und aussortiert.

Gemäß einer vorteilhaften Ausführungsform des erfindungsgemäßen Verfahrens wird die Möglichkeit oder Unmöglichkeit, aus den Werten der pro Spektrallinie ermittelten Werten für den ohmschen Widerstand Rf Ausreißer nach vorgebbaren Kriterien zu ermitteln, zur Ermittlung eines Bewertungskriteriums für die Zuverlässigkeit der Messung verwendet.

Ein weiterer Aspekt der vorliegenden Erfindung betrifft eine Einrichtung zur Bestimmung des Isolationswiderstandes in einem ungeerdeten elektrischen Gleich-oder Wechselstromnetz, wobei das Gleich- oder Wechselstromnetz einen ohmschen ($R_f$) sowie kapazitiven (Cf) Isolationswiderstand zwischen Netz und Erde aufweist, wobei die Einrichtung eine Messvorrichtung umfasst, die dazu eingerichtet ist, um das oben beschriebene Verfahren durchzuführen.

Die Erfindung sowie weitere Vorteile und Ausführungsvarianten der Erfindung sollen nun exemplarisch und schematisch anhand eines Ausführungsbeispiels und anhand der Figuren näher erläutert und beschrieben werden.

Es zeigen:

Figur 1    eine beispielhafte Legendre-Impulsfolge mit p = 17,

Figur 2    das Amplitudenspektrum der beispielhaften Legendre-Impulsfolge mit p = 17,

Figur 3    ein schematisches und vereinfachtes Ersatzschaltbild zur Ermittlung der Messspannung,

Figur 4    exemplarisch und schematisch ein Blockschaltbild des erfindungsgemäßen Verfahrens,

Figur 5    eine Darstellung des interpolierten Amplitudengangs basierend auuf dem Legendre-Signal.

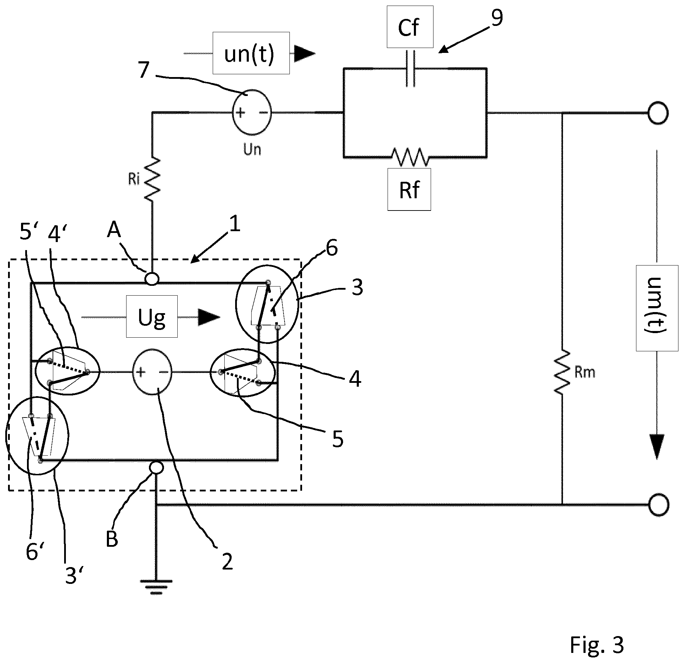

Dem erfindungsgemäßen Verfahren liegt ein in der Figur 3 gezeigtes Ersatzschaltbild für die Messschaltung zugrunde. Dabei bezeichnet Rf den ohmschen Anteil des Isolationswiderstandes der zu überwachenden Leitung 9 zwischen Netz und Erde, Cf bezeichnet den kapazitiven Anteil des Isolationswiderstandes der zu überwachenden Leitung 9 zwischen Netz und Erde. Ein Messsignalgenerator 1 mit den beiden anschlusspunkten A und B erzeugt aus einer geschalteten Gleichspannungsquelle 2 die Impulswechselspannung Ug, die an den Anschlusspunkten A und B anliegt und zur Messung der zu überwachenden Leitung aufgeprägt wird, mit den Impulsspannungswerten +Ug, - Ug, 0, beziehungsweise in normierter Darstellung mit den Werten +1, -1, 0, mit gleichen Pulsdauern, wobei sich das durch die Folge der Pulsamplituden ergebende Muster nach einer bestimmten Periode wiederholt.

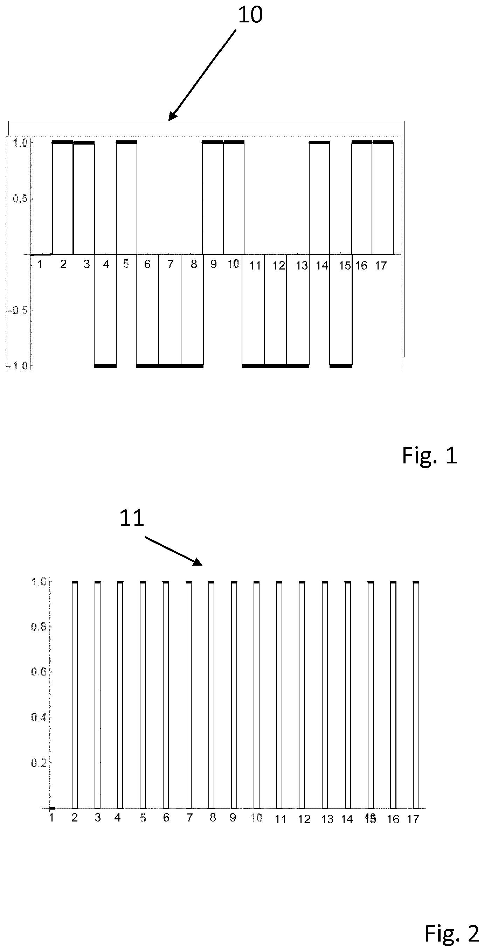

Figur 1 zeigt exemplarisch eine Periode 10 einer solchen Impulsfolge. Es ist in Figur 1 beispielhaft eine Periode 10 einer Legendre-Impulsfolge mit p= 17 gezeigt. Die normierten Impulsspannungswerte sind 0 für den ersten, +1 für den zweiten und dritten, -1 für den 4., +1 für den fünften, -1 für den sechsten, siebten und achten, +1 für den neunten und zehnten, -1 für den elften, zwölften und dreizehnten, +1 für den vierzehnten, -1 für den fünfzehnten, +1 für den sechzehnten und siebzehnten Impuls. Ab dem achtzehnten Impuls wiederholt sich das Impulsspannungsmuster. Figur 2 zeigt in normierter Darstellung das Amplitudenspektrum 11 der in Figur 1 dargestellten Periode 10 der Legendre-Impulsfolge.

Figur 3 zeigt, lediglich schematisch und exemplarisch, eine Anordnung von zwei Schalterpaaren 3, 3'; 4,4' in dem Messsignalgenerator 1. In Abhängigkeit der jeweiligen Schalterstellung in den Schaltern 3, 3'; 4, 4' liegt zwischen den Punkten A und B entweder eine negative Gleichspannung -Ug ( diese Schalterstellung ist in der Figur 3 dargestellt), oder eine positive Gleichspannung +Ug (dies entspricht der Schalterstellung gemäß der punktierten Linien 5, 5'), oder die Punkte A und B sind kurzgeschlossen (dies entspricht der Schalterstellung gemäß der gestrichelten Linien 6, 6') und es liegt zwischen A und B ein Potential von 0 an.

Ri ist der Innenwiderstand der ohmschen Netzankopplung der Impulsspannung Ug, Rm ist der Messwiderstand. Eine Störspannungsquelle 7 symbolisiert den Ursprung einer Störspannung Un(t). Die Überlagerung der Impulsspannung Ug und der Störspannung un(t) liegt an dem Messwiderstand Rm als Messspannung um(t) an.

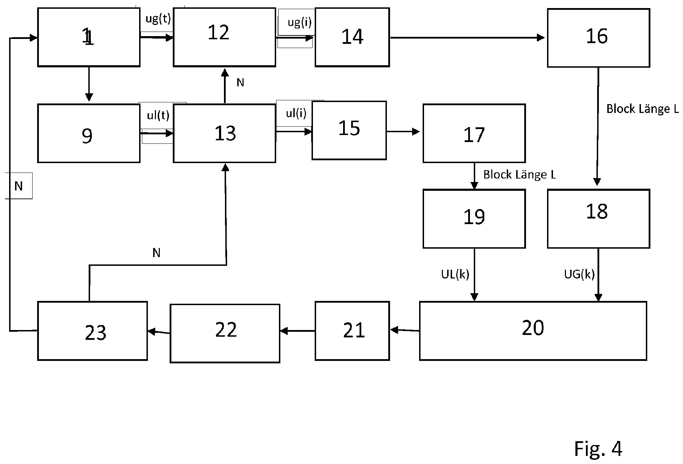

Es werde nun das erfindungsgemäße Verfahren anhand des Blockschaltbildes in Figur 4 erläutert. Der Messsignalgenerator 1 erzeugt als ein Messsignal aus einer geschalteten Gleichspannungsquelle, siehe Figur 3, Spannungssignale +Ug, -Ug und 0, beziehungsweise in normierter Darstellung 1,-1 und 0, mit gleichen Pulsdauern, wobei sich das durch die Folge der Pulsamplituden ergebene Muster nach einer bestimmten Periode wiederholt, siehe Figur 1. Das Messsignal wird an das System der zu überwachenden Leitung 9, siehe Figur 3, angelegt. Die normierten Amplituden entsprechen den Werten einer Legendre-Folge, was impliziert, dass die Periodenlänge einer Primzahl entspricht. Die aufwändige Berechnung der Werte der Legendre-Folge wird vorzugsweise im Vorfeld durchgeführt, so dass der Impulsgenerator beziehungsweise Messsignalgenerator 1 seine Ausgabewerte einer darauf basierenden Tabelle entnehmen kann.

Zwei Abtaster 12 und 13 digitalisieren das Impulsgeneratorsignal ug(t) und die Systemantwort ul(t) der Leitung 9, wobei die Signale mit einer festen Frequenz abgetastet werden. Die Abtastfrequenz ist dabei so bemessen, dass sie ein ganzzahliger Teiler, vorzugsweise eine Zweierpotenz, der durch den Messsignalgenerator 1 erzeugten Impulsdauer entspricht.

Die abgetasteten Werte werden über Vorverarbeitungsstufen 14 und 15 geführt. In diesen Vorverarbeitungsstufen 14, 15 können z.B. systematische Störungen entfernt werden und/oder eine Gleichanteilskompensation oder Extraktion vorgenommen werden.

In einer Folgestufe werden alle zu einem Abtastimpuls gehörenden Abtastwerte über Dezimationsstufen 16, 17 geführt. Die Dezimationsstufen 16, 17 reduzieren die Anzahl der Abtastwerte pro Impuls auf genau einen Abtastwert. Dies hat zur Folge, dass im eingeschwungenen Zustand die P Impulse einer Legendrefolge in P Werte überführt werden. Am Ausgang von Block 16 sollte die generierte Wertefolge einer Legendrefolge weitgehend entsprechen. Am Ausgang von Block 17 erhält man die abgetastete Systemantwort des IT-Netzes 9 auf die Legendrefolge.

Der zweikanalige Aufbau hat den vorteilhaften Effekt, dass Signalverzerrungen oder Verzögerungen sich weitgehend gleichartig auf beide Kanäle auswirken und sich so in den nachfolgenden Auswertungsstufen kompensieren können.

Werden jeweils P aufeinanderfolgende Werte der beiden Folgen einer Spektralzerlegung unterzogen, in den Spektralzerlegungsstufen 18, 19, so erhält man die abgetasteten Spektren UG(k) und UL(k) der Legendresequenz und der Systemantwort des IT Netzes auf die Legendresequenz. Letztere können als Produkt des Legendrespektrums mit dem Spektrum der IT-Systems interpretiert werden.

Da die prinzipielle Struktur des Systems der zu überwachenden Leitung 9 als bekannt vorausgesetzt werden kann (siehe Figur 3), kann aus jedem Spektralkomponentenpaar der Ableitwiderstand Rf und die parasitäre Kapazität Cf ermittelt werden.

Dazu werden die abgetasteten Spektren UG(k) und UL(k) einem Auswertungsblock 20 und einem Berechnungsblock 21 zugeführt.

Jede Spektralkomponente wird durch eine komplexe Zahl repräsentiert. In Polarschreibweise wird die Generatorkomponente durch $\overline{U_g} = |U_g|e^{\phi g}$ und die Systemantwort durch $\overline{U_l} = |U_l|e^{\phi l}$ beschrieben.

Da nur die Phasendifferenz beider Schwingungen von Interesse ist, kann ohne Beschränkung der Allgemeinheit die Phase der Generatorkomponente zu Null gesetzt werden und die der Systemantwort durch die Differenzphase $\phi_m$ = $\phi_l$ - $\phi_g$ ersetzt werden.

Die Spektralzerlegung verwendet jeweils die letzten P Werte, die aus den Dezimationsstufen 16, 17 kommen. Obwohl es im Prinzip möglich wäre, nach jedem Dezimatorausgangswert die komplette Spektralzerlegung erneut durchzuführen, da das Eingangssignal periodisch ist, ist es ausreichend, die Auswertung nur alle P Werte durchzuführen. Wenn allerdings Änderungen am System schneller erkannt werden sollen, kann die Auswertung auch häufiger, z.B. nach jeweils P12 oder P14 Ausgangswerten durchgeführt werden. Dann sind die Ergebnisse allerdings nicht mehr völlig unabhängig.

Eine Knoten- und Maschenanalyse des Systems führt dann auf folgende Bestimmungsgleichung für den Ableitwiderstand pro Spektrallinie, die im Berechnungsblock 21 ermittelt wird

$$R_f = \frac{R_m(2U_gU_l Cos[\phi_m] - (U_g{}^2 + U_l{}^2))}{U_l(1 - U_g Cos[\phi_m])}$$

Die entsprechende Gleichung für die parasitäre Kapazität lautet mit diesen Definitionen:

$$C_e = \frac{U_gU_l Sin[\phi m]}{R_m\omega(U_g{}^2 + U_l{}^2 - 2U_gU_l Cos[\phi m])}$$

Hierbei beschreibt $\omega$ die Kreisfrequenz der zugehörigen Spektralkomponente.

Zerlegt man ein Eingangssignal in P Spektralkomponenten, so ergeben sich im Prinzip P Gleichungen für die Ermittlung der Kenngrößen Rf und Cf. In der Praxis können nur P-1 Gleichungen herangezogen werden, da die erste Spektralkomponente für k=0 der Legendrefolge die Amplitude "0" hat.

Unter der Annahme, dass die Störungen nur einige Spektralkomponenten betreffen, werden die Auswertungsergebnisse für alle Spektrallinien miteinander verglichen und Ausreißer aussortiert. Dies erfolgt im Eliminationsblock 22. Die verbleibenden Spektrallinien werden gewichtet und gemittelt. Dies erfolgt im Bereinigungsblock 23.

Wenn die Messdaten die Erkennung von Ausreißern nicht eindeutig ermöglichen, ist dies ein Kennzeichen für eine inkonsistente Messung.

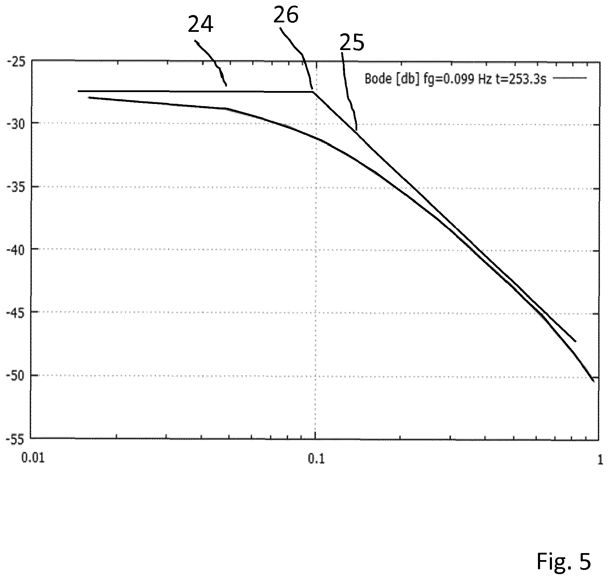

Durch die Anregung mit einer Legendresequenz ist es möglich, den Frequenzgang des Systems näherungsweise zu ermitteln. In doppelt logarithmischer Darstellung lässt sich durch Interpolation des Ampituden- oder Phasenspektrums ein Bodediagramm herleiten, siehe Figur 5. Dieses hat zwei Approximationsgeraden, eine erste horizontale Approximationsgerade 24 und eine zweite Approximationsgerade 25 mit einer Steigung von -20db/Dekade. Aus der Lage der horizontalen Approxiationsgeraden 24 lässt sich der Ableitwiderstand $R_f$ und aus dem Schnittpunkt 26 dieser Geraden 24 mit der zweiten Approximationsgeraden 25 mit der Steigung -20dB/Dekade lässt sich die Zeitkonstante $\tau$ = $R_f * C_e$ = $1/f_g$ ermitteln. Dies Verfahren ist sehr robust und baut nicht auf den oben angegebenen Formeln auf.

Für die Ermittlung der Zeitkonstante kann auch der interpolierte Phasengang herangezogen werden.

Die Bestimmung der Zeitkonstanten ist insofern von Interesse, als diese zur Wahl der Periodendauer der Legendresequenz herangezogen werden kann. Untersuchungen zur Fehlertoleranz haben ergeben, dass die Messperiode in der Größenordnung der Zeitkonstante des IT-Netzes liegen sollte. Die Periodendauer der Legendresequenz wird durch Wahl von "N" beeinflusst. N gibt das Verhältnis von Impulsdauer zu Abtastintervall des Abtasters an. Je größer N gewählt wird umso länger dauert eine Messperiode.

Wie anhand des systemtypischen Bodediagramms (siehe Figur 5) deutlich wird, werden durch das System die höheren Spektralkomponenten stark gedämpft und tragen somit nur noch wenig zur Systemanalyse bei. Um dies zu kompensieren, ist eine Anhebung der Signalenergie für Frequenzen jenseits der Grenzfrequenz $f_g$ wünschenswert.

Eine mögliche Maßnahme ist die empirische Modifikation der 3-wertigen Signalfolge so, dass Spektralkomponenten oberhalb der Grenzfrequenz verstärkt werden.

Eine weitere Maßnahme zur Anpassung des Generatorsignalspektrums ist die Realisierung eines analogen oder digitalen Filters, das den Systemfrequenzgang teilweise kompensiert.

Allerdings müsste ein analoges Filter aufwändig, zum Beispiel durch geschaltete Kapazitäten, an die jeweiligen Netzverhältnisse angepasst werden.

Ein digitales Filter wäre deutlich einfacher zu realisieren. Das Generatorausgangssignal wäre dann allerdings nicht mehr dreiwertig, sondern müsste aufwändig durch eine analoge Endstufe realisiert werden.

Ein vorteilhafter Kompromiss zur Optimierung des Spektrums des Messsignals ist die Kombination aus Digitalfilter mit nachgeschalteter Quantisierungsstufe, die aus dem quasi analogen gefilterten Digitalsignals in ein 3-wertiges Signal überführt.

Bezugszeichenliste

| 1 | Messsignalgenerator |
|---|---|
| 2 | Gleichspannungsquelle |
| 3, 3' | Schalter |
| 4, 4' | Schalter |
| 5, 5' | Punktierte Linie |
| 6, 6' | Gestrichelte Linie |
| 7 | Störspannungsquelle |
| 9 | Zu überwachende Leitung |
| 10 | Periode einer Legendre-Impulsfolge |
| 11 | Amplitudenspektrum der Legendre-Impulsfolge |
| 12 | Abtaster |
| 13 | Abtaster |
| 14 | Vorverarbeiterstufe |
| 15 | Vorverarbeiterstufe |
| 16 | Dezimationsstufe |
| 17 | Dezimationsstufe |
| 18 | Spektralzerlegungsstufe |
| 19 | Spektralzerlegungsstufe |
| 20 | Auswertungsblock |
| 21 | Berechnungsblock |
| 22 | Eliminationsblock |
| 23 | Bereinigungsblock |
| 24 | Erste Approximationsgerade |
| 25 | Zweite Approximationsgerade |
| 26 | Schnittpunkt |

**Patentansprüche**

1. Verfahren zur Bestimmung des Isolationswiderstandes in einem ungeerdeten elektrischen Gleich-oder Wechselstromnetz (9), wobei das Gleich- oder Wechselstromnetz (9) einen ohmschen ($R_f$) sowie kapazitiven ($C_f$) Isolationswiderstand zwischen Netz und Erde aufweist, wobei eine periodisch sich wiederholende Folge von Spannungsimpulsen über eine ohmsche Netzankopplung ($R_i$) zwischen Netz und Erde an das zu überwachende Gleich-oder Wechselstromnetz angelegt wird,

wobei die Folge aus Spannungsimpulsen mit drei verschiedenen, vordefinierten Impulsspannungswerten gebildet ist, **dadurch gekennzeichnet, dass**
die Anzahl der in einer Periode angelegten Spannungsimpulse einer Primzahl p entspricht, wobei die Amplitude der Impulsspannungswerte durch eine Legendre-Folge:

$$S(n) = n^{(p-1)/2} \bmod p,$$

mit der Primzahl p, die größer 2 ist und einer primzahligen Länge N = p definiert ist.

2. Verfahren nach Anspruch 1, **dadurch gekennzeichnet, dass** eine durch die Folge aus Spannungsimpulsen hervorgerufene Spannungsänderung des Gleich-oder Wechselstromnetzes spektral zerlegt wird und jede Spektralkomponente zur entsprechenden Spektralkomponente der eingangsseitigen Folge aus Spannungsimpulsen zur Ermittlung des ohmschen Isolationswiderstandes in Beziehung gesetzt wird.

3. Verfahren nach Anspruch 2, **dadurch gekennzeichnet, dass** diejenigen Messergebnisse identifiziert werden, die von der Majorität der Messergebnisse abweichen, und dass diese vor der weiteren Verarbeitung eliminiert werden, so dass dadurch der Einfluss von schmalbandigen Störungen unbekannter Frequenz reduziert werden kann.

4. Verfahren nach einem der vorigen Ansprüche, **dadurch gekennzeichnet, dass** ein Messsignalgenerator (1) aus einer geschalteten Gleichspannungsquelle (2) ein Messsignal erzeugt, das als eine sich wiederholende Folge von Spannungsimpulsen mit drei verschiedenen, vordefinierten Impulsspannungswerten gebildet ist, wobei die Anzahl der in einer Periode angelegten Spannungsimpulse einer Primzahl entspricht, wobei die Amplitude der Impulsspannungswerte durch eine Legendre-Folge definiert ist.

5. Verfahren nach Anspruch 4, **dadurch gekennzeichnet, dass** die Berechnung der Werte der Legendre-Folge im Vorfeld der Messung durchgeführt wird, so dass der Messsignalgenerator (1) seine Ausgabewerte einer vorab berechneten Wertetabelle entnehmen kann.

6. Verfahren nach einem der vorigen Ansprüche, **dadurch gekennzeichnet, dass** ein erster Abtaster (12) das von dem Messsignalgenerator (1) erzeugte Messsignal und ein zweiter Abtaster (13) das Signal der Systemantwort des Gleich-oder Wechselstromnetzes (9) mit einer festen Frequenz abtasten, wodurch abgetastete Spektren UG(k) und UL(k) entstehen, wobei die Abtastfrequenz so bemessen ist, dass sie einem ganzzahligen Teiler der Impulsdauer der durch den Messsignalgenerator (1) erzeugten Spannungsimpulse entspricht.

7. Verfahren nach Anspruch 6, **dadurch gekennzeichnet, dass** die abgetasteten Spektren UG(k) und UL(k) einem Berechnungsblock (21) zugeführt werden, in dem pro Spektrallinie ein Wert für den ohmschen Widerstand Rf ermittelt wird.

8. Verfahren nach Anspruch 7, **dadurch gekennzeichnet, dass** die Werte der pro Spektrallinie ermittelten Werte für den ohmschen Widerstand Rf miteinander verglichen und Ausreißer aufgrund vorgebbarer Kriterien ermittelt und aussortiert werden.

9. Verfahren nach Anspruch 8, **dadurch gekennzeichnet, dass** die Möglichkeit oder Unmöglichkeit, aus den Werten der pro Spektrallinie ermittelten Werten für den ohmschen Widerstand Rf Ausreißer nach vorgebbaren Kriterien zu ermitteln, zur Ermittlung eines Bewertungskriteriums für die Zuverlässigkeit der Messung verwendet wird.

10. Einrichtung zur Bestimmung des Isolationswiderstandes in einem ungeerdeten elektrischen Gleich-oder Wechselstromnetz, wobei das Gleich- oder Wechselstromnetz einen ohmschen ($R_f$) sowie kapazitiven ($C_f$) Isolationswiderstand zwischen Netz und Erde aufweist, wobei die Einrichtung eine Messvorrichtung umfasst, die dazu eingerichtet ist, um das Verfahren gemäß einem der vorigen Ansprüche durchzuführen.

## Claims

1. Method for determining the insulation resistance in an unearthed electrical DC or AC network (9), the DC or AC network (9) having an ohmic ($R_f$) and capacitive (Cf) insulation resistance between the network and earth, a periodically repeating sequence of voltage pulses being applied to the DC or AC network to be monitored via an ohmic network coupling (Ri) between the network and earth,

the sequence being formed from voltage pulses with three different, predefined pulse voltage values, **characterized in that** the number of voltage pulses applied in one period corresponds to a prime number p, the amplitude of the pulse voltage values being defined by a Legendre sequence:

$$S(n) = n^{(p-1)/2} \bmod p,$$

is defined with prime number p greater than 2 and prime length N = p.

2. Method according to claim 1, **characterized in that** a voltage change of the DC or AC network caused by the sequence of voltage pulses is spectrally decomposed and each spectral component is related to the corresponding spectral component of the input-side sequence of voltage pulses for determining the ohmic insulation resistance.

3. Method according to claim 2, **characterized in that** those measurement results are identified which deviate from the majority of the measurement results and that these are eliminated before further processing, so that thereby the influence of narrowband interferences of unknown frequency can be reduced.

4. Method according to any one of the preceding claims, **characterized in that** a measurement signal generator (1) generates from a switched DC voltage source (2) a measurement signal formed as a repeating sequence of voltage pulses with three different predefined pulse voltage values, the number of voltage pulses applied in one period corresponding to a prime number, the amplitude of the pulse voltage values being defined by a Legendre sequence.

5. Method according to claim 4, **characterized in that** the calculation of the values of the Legendre sequence is carried out in advance of the measurement, so that the measurement signal generator (1) can take its output values from a value table calculated in advance.

6. Method according to one of the previous claims, **characterized in that** a first sampler (12) samples the measurement signal generated by the measurement signal generator (1) and a second sampler (13) samples the signal of the system response of the DC or AC network (9) at a fixed frequency, resulting in sampled spectra UG(k) and UL(k), the sampling frequency being dimensioned such that it corresponds to an integer divisor of the pulse duration of the voltage pulses generated by the measurement signal generator (1).

7. Method according to claim 6, **characterized in that** the sampled spectra UG(k) and UL(k) are fed to a calculation block (21) in which a value for the ohmic resistance Rf is determined per spectral line.

8. Method according to claim 7, **characterized in that** the values of the ohmic resistance Rf determined per spectral line are compared with one another and outliers are determined and sorted out on the basis of predeterminable criteria.

9. Method according to claim 8, **characterized in that** the possibility or impossibility of determining outliers according to predeterminable criteria from the values of the ohmic resistance Rf determined per spectral line is used to determine an evaluation criterion for the reliability of the measurement.

10. A device for determining the insulation resistance in an unearthed DC or AC electrical network, the DC or AC network having an ohmic ($R_f$) and capacitive ($C_f$) insulation resistance between the network and earth, the device comprising a measuring device arranged to perform the method according to any one of the preceding claims.

**Revendications**

1. Procédé de détermination de la résistance d'isolation dans un réseau électrique continu ou alternatif (9) non relié à la terre, le réseau électrique continu ou alternatif (9) présentant une résistance d'isolation ohmique ($R_f$) ainsi que capacitive ($C_f$) entre le réseau et la terre, une séquence qui se répète périodiquement d'impulsions de tension aux bornes d'une connexion de réseau ohmique ($R_f$) entre le réseau et la terre étant appliquée au réseau électrique continu ou alternatif à surveiller, la séquence d'impulsions de tension étant formée avec trois valeurs de tension d'impulsion prédéfinies différentes, **caractérisé en ce que** le nombre d'impulsions de tension appliquées en une période correspond à un nombre premier, l'amplitude des valeurs de tension d'impulsion étant définie par un polynôme de Legendre :

$$S(n) = n^{(p-1)/2} \bmod p,$$

avec le nombre primaire p, lequel est supérieur à 2 et définit une longueur N = p dont la valeur est primaire.

2.  Procédé selon la revendication 1, **caractérisé en ce qu'**une modification de la tension du réseau électrique continu ou alternatif, provoquée par la séquence d'impulsions de tension, est décomposée spectralement et chaque composante spectrale est mise en relation avec la composante spectrale correspondante de la séquence côté entrée d'impulsions de tension en vue de déterminer la résistance d'isolation ohmique.

3.  Procédé selon la revendication 2, **caractérisé en ce que** les résultats de mesure qui s'écartent de la majorité des résultats de mesure sont identifiés, et **en ce que** ceux-ci sont éliminés de la suite du traitement, de sorte que l'influence des perturbations à bande étroite de fréquence inconnue puisse ainsi être réduite.

4.  Procédé selon l'une des revendications précédentes, **caractérisé en ce qu'**un générateur de signal de mesure (1) génère, à partir d'une source de tension continue (2) commutée, un signal de mesure qui est formée d'une séquence qui se répète d'impulsions de tension avec trois valeurs de tension d'impulsion prédéfinies différentes, le nombre d'impulsions de tension appliquées en une période correspondant à un nombre premier, l'amplitude des valeurs de tension d'impulsion étant définie par un polynôme de Legendre.

5.  Procédé selon la revendication 4, **caractérisé en ce que** le calcul des valeurs du polynôme de Legendre étant effectué en phase préparatoire de la mesure, de sorte que le générateur de signal de mesure (1) peut prélever ses valeurs de sortie d'un tableau de valeurs calculé préalablement.

6.  Procédé selon l'une des revendications précédentes, **caractérisé en ce qu'**un premier échantillonneur (12) échantillonne, avec une fréquence fixe, le signal de mesure généré par le générateur de signal de mesure (1) et un deuxième échantillonneur (13) le signal de réponse du système du réseau électrique continu ou alternatif (9), moyennant quoi sont produits des spectres échantillonnés UG(k) et UL(k), la fréquence d'échantillonnage étant dimensionnée de telle sorte qu'elle corresponde à un diviseur entier de la durée d'impulsion des impulsions de tension générées par le générateur de signal de mesure (1).

7.  Procédé selon la revendication 6, **caractérisé en ce que** les spectres échantillonnés UG(k) et UL(k) sont acheminés à un bloc de calcul (21) dans lequel une valeur pour la résistance ohmique Rf est déterminée pour chaque ligne spectrale.

8.  Procédé selon la revendication 7, **caractérisé en ce que** les valeurs des valeurs pour la résistance ohmique Rf déterminées pour chaque ligne spectrale sont comparées entre elles et des valeurs aberrantes sont déterminées sur la base de critères pouvant être prédéfinis et éliminées par triage.

9.  Procédé selon la revendication 8, **caractérisé en ce que** la possibilité ou l'impossibilité de déterminer des valeurs aberrantes d'après des critères pouvant être prédéfinis à partir des valeurs des valeurs pour la résistance ohmique Rf déterminées pour chaque ligne spectrale est utilisée pour la détermination d'un critère d'évaluation de la fiabilité de la mesure.

10. Dispositif de détermination de la résistance d'isolation dans un réseau électrique continu ou alternatif (9) non relié à la terre, le réseau électrique continu ou alternatif (9) présentant une résistance d'isolation ohmique ($R_f$) ainsi que capacitive ($C_f$) entre le réseau et la terre, le dispositif comportant un arrangement de mesure qui est conçu pour mettre en œuvre le procédé selon l'une des revendications précédentes.

10

Fig. 1

11

Fig. 2

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2717063 A1
- EP 2256506 A1